# EUROPÄISCHE PATENTSCHRIFT

(11) **EP 4 205 239 B1**
(45) Veröffentlichungstag und Bekanntmachung des Hinweises auf die Patenterteilung: **03.06.2026**
(21) Anmeldenummer: 21752023.8
(22) Anmeldetag: 29.07.2021
(51) Int. Cl.: H01R 12/52, H01R 12/57, H01R 12/58, H01R 43/02, H01R 4/02, H05K 1/184, H05K 3/325

(54) **ELEKTRISCHE KONTAKTANORDNUNG SOWIE LEITERPLATTENANORDNUNG UND VERFAHREN ZU DEREN HERSTELLUNG**
ELECTRIC CONTACT ASSEMBLY, PRINTED CIRCUIT BOARD ASSEMBLY, AND METHOD FOR PRODUCING SAME
ENSEMBLE CONTACT ÉLECTRIQUE, ENSEMBLE CARTE DE CIRCUIT IMPRIMÉ ET SON PROCÉDÉ DE PRODUCTION

(30) Priorität: 31.08.2020 DE 102020210961
(43) Veröffentlichungstag der Anmeldung: 05.07.2023
(73) Patentinhaber: Robert Bosch GmbH, 70442 Stuttgart (DE)
(72) Erfinder: RAFF, Matthias, 72336 Balingen (DE); MEIER, Andreas, 72793 Pfullingen (DE); OTTO, Andreas, 99820 Hoerselberg-Hainich (DE)
(86) Internationale Anmeldenummer: PCT/EP2021/071251
(87) Internationale Veröffentlichungsnummer: WO 2022/042990

(56) Entgegenhaltungen:
- DE-A1- 102016 218 788
- DE-A1- 102017 206 217
- JP-A- 2011 138 894

## Beschreibung

### Stand der Technik

Die vorliegende Erfindung betrifft eine elektrische Kontaktanordnung zur elektrischen Kontaktierung von Elementen einer Leiterplattenanordnung oder dgl., sowie eine Leiterplattenanordnung mit derartiger elektrischer Kontaktanordnung und ein Verfahren zu deren Herstellung.

Elektrische Kontaktanordnungen sind beispielsweise zur Gruppe der kalten Kontaktiertechnik zuzuordnen, bei der ein nichtlösbarer kraft- und formschlüssiger elektrischer Kontakt erfolgt. Hierbei wird der elektrische Kontakt allein durch ein Verspressen oder ein Verklemmen der Fügepartner hergestellt. Derartige Einpressverbindungen sind bei Leiterplatten beispielsweise von Steuergeräten für Fahrzeuge oder dgl. im Einsatz. Hierbei ergibt sich eine große Variantenvielzahl von Einzelpins bis hin zu großen Steckerleisten mit mehreren einhundert elektrischen Kontakten. Insbesondere bei einer großen Anzahl von einzupressenden Pins steigen die Anforderungen an eine Genauigkeit der Pins und eine Genauigkeit der Leiterplatte sowie eine Positionierung während des Pressvorgangs. Ein weiterer Problemkreis ergibt sich dadurch, dass vermehrt sog. IMS-Leiterplatten (Insulated Metal Substrate) verwendet werden, bei denen ein Basisbereich aus einem elektrisch leitfähigen Material und eine darauf aufgebrachte Isolationslage verwendet wird. Aufgrund der technologischen Anforderungen ist es hierbei nicht möglich, eine Durchkontaktierung mittels Einpresspins herzustellen. Um eine Verbindung zwischen der IMS-Leistungselektronik und weiteren Leiterplatten oder elektronischen Elementen herzustellen, werden unterschiedliche Verbindungskonzepte, beispielsweise mittels Kabel oder mittels SMD-Pressfitpins verwendet. Kabellösungen benötigen hierbei immer einen aufwendigen Kontaktierprozess oder einen teuren und großen Bauraum einnehmenden Stecker. Aus der DE 10 2008 007 310 B4 ist ferner ein SMD-Pressfitpin bekannt, welcher während des Lötens mittels Schablonen in Position gehalten werden. Das Zuführen sowie Entfernen der Schablone unterbricht allerdings den SMD-Fertigungsprozess und führt somit zu erhöhten Fertigungskosten und Durchlaufzeiten.

Die DE 10 2016 218 788 A1 beschreibt ein Verbindungselement, zur Verbindung einer ersten Leiterplatte mit einer zweiten Leiterplatte, umfassend einen Mittenabschnitt, der sich entlang einer Längsachse erstreckt; einen Kopfabschnitt, der zur Oberflächenmontage an einer Oberfläche der ersten Leiterplatte eingerichtet ist; und einen Einpressabschnitt, der zum Einpressen in eine Aussparung der zweiten Leiterplatte eingerichtet ist. In der JP 2011-138894 A wird ein Stiftkopf verwendet, um eine erste Leiterplatte und eine zweite Leiterplatte elektrisch zu verbinden und dabei einen annähernd parallelen Zustand mit einem vorbestimmten Abstand aufrechtzuerhalten.

### Offenbarung der Erfindung

Die erfindungsgemäße elektrische Kontaktanordnung zur elektrischen Kontaktierung an einer Leiterplatte oder dgl. mit den Merkmalen des Anspruchs 1 weist demgegenüber den Vorteil auf, dass eine sehr kostengünstige und sichere elektrische Kontaktierlösung gefunden ist. Insbesondere kann die elektrische Kontaktierung dabei in einer SMD-Fertigung ohne Sonderprozesse oder aufwendige und zeitraubende Fertigungsschritte integriert werden. Die erfindungsgemäße elektrische Kontaktanordnung benötigt dabei nur einen minimalen Bauraum und ermöglich weiterhin eine freie Gestaltung der Kontaktierung, insbesondere hinsichtlich einer Position und einer Anzahl der elektrischen Kontakte. Dabei kann die elektrische Kontaktanordnung auch flexibel auf unterschiedlichste Anforderungen während der Herstellung von Leiterplatten oder dgl. angepasst werden. Ferner ermöglicht die Erfindung eine Reduzierung einer Toleranzkette aufgrund einfacher und genauer Fügeverfahren. Die Fügeverfahren können dabei bei Umgebungstemperatur ausgeführt werden. Dadurch ist auch eine einfache Prozessführung und Überwachung der elektrischen Kontaktierung möglich. Dies wird erfindungsgemäß dadurch erreicht, dass die elektrische Kontaktanordnung einen Montagering mit einer Öffnung sowie einen Einpressstift aufweist. Der Montagering ist eingerichtet, an der Leiterplatte oder dgl. fixiert zu werden. Dabei kann der Montagering als SMD-Bauteil in den SMD-Fertigungsprozess eingebunden werden. Der Einpressstift weist eine erste und eine zweite Zone auf. Die erste Zone weist dabei eine größere mechanische Flexibilität als die zweite Zone auf. Somit umfasst der Einpressstift eine erste flexible Zone und eine zweite starre Zone. Die erste flexible Zone ist dabei eingerichtet, an einem weiteren elektronischen Bauteil, beispielsweise einer zweiten Leiterplatte, fixiert zu werden. Die zweite starrere Zone ist mittels einer ersten Presspassung in die Öffnung des Montagepins gefügt. Weiter umfasst die elektrische Kontaktanordnung eine Einpresshilfseinrichtung, die an der zweiten Zone angeordnet ist. Diese Einpresshilfseinrichtung ist als umlaufender geschlossener Ringflansch an der zweiten Zone fixiert. Der umlaufende Ringflansch umfasst eine Einpressschulter für den Angriff eines Einpresswerkzeugs.

Die Einpresshilfseinrichtung ist vorzugsweise an der zweiten, starreren Zone fixiert, beispielsweise mittels Löten oder Schweißen. Alternativ ist die Einpresshilfseinrichtung und die zweite Zone aus einem einzigen Material hergestellt.

Erfindungsgemäß wird unter einer Leiterplatte ein Schaltungsträger verstanden, beispielsweise ein PCB (Printed Circuit Board) aus FR4 Material, oder ein Schaltungsträger aus Keramiksubstraten (LTCC (Low Temperature Cofired Ceramics), DBC (Direct Bonded Copper)) sowie anderen FR-Materialien.

Somit kann die elektrische Kontaktanordnung in einem ersten Schritt durch Fixieren des Montagerings auf einer Leiterplatte, insbesondere einer IMS-Leiterplatte, und einem anschließenden Fügeschritt des Einpressstifts in die Öffnung des Montagerings bereitgestellt werden. In einem weiteren Fügeschritt kann dann die elektrische Verbindung zwischen der ersten Leiterplatte und einer zweiten Leiterplatte oder dgl. durch Fügen des Einpressstifts an der ersten, flexibleren Zone mit der zweiten Leiterplatte fortgeführt werden.

Der Montagering kann beispielsweise einfach als Stanzbauteil mit einer zentralen Öffnung für die erste Pressverbindung hergestellt werden. Gegebenenfalls kann der Montagering mittels galvanischer Verfahren beschichtet werden. Die Fixierung des Montagerings kann dann in eine standardisierte SMD-Fertigung integriert werden. Der Montagering kann mittels unterschiedlicher Fügeverfahren auf eine Oberfläche gefügt werden, beispielsweise mittels eines Lötverfahrens. Nach dem Fixieren des Montagerings kann dann der Einpressstift in die Öffnung des Montagerings mittels der ersten Pressverbindung gefügt werden. Dadurch kann eine sehr genaue Positionierung der elektrischen Kontaktanordnung auf der Leiterplatte sichergestellt werden.

Die Unteransprüche zeigen bevorzugte Weiterbildungen der Erfindung.

Der Einpressstift, umfassend die erste und zweite Zone, ist vorzugsweise aus einem Material einstückig ausgebildet. Vorzugsweise wird der Einpressstift aus einem Drahtmaterial oder Bandmaterial mit einer Dicke von 0,4 bis 0,8 mm hergestellt.

Die erste flexiblere Zone des Einpressstifts wird vorzugsweise durch eine geometrische Umformung des Basismaterials des Einpressstifts hergestellt. Somit ist die erste Zone ein geometrischer Umformbereich, welcher beispielsweise eine ovale Öse oder ein Ring oder dgl. sein kann.

Vorzugsweise ist die zweite Zone, welche weniger flexibel als die erste Zone des Einpressstifts ist, ein Vollmaterialbereich, beispielsweise ein zylindrischer Bereich des Ausgangsmaterials des Einpressstifts.

Weiter bevorzugt ist die flexible erste Zone für eine zweite Presspassung mit dem weiteren elektronischen Bauteil eingerichtet. Somit weist der Einpressstift der elektrischen Kontaktanordnung zwei Pressverbindungsbereiche auf.

Ferner betrifft die vorliegende Erfindung eine Leiterplattenanordnung, umfassend wenigstens eine erste Leiterplatte, welche einen Basisbereich aus einem elektrisch leitfähigen Material und eine Isolationslage auf dem Basisbereich aus einem elektrisch nichtleitenden Material aufweist und eine erfindungsgemäße elektrische Kontaktanordnung umfasst. Die Leiterplatte ist vorzugsweise eine IMS-Leiterplatte und weiter bevorzugt mittels SMD-Fertigung hergestellte Leiterplatte.

Dadurch ist es möglich, den Montagering in den SMD-Fertigungsablauf als zu bestückendes SMD-Bauteil zu integrieren und die Fixierung des Montagerings innerhalb des üblichen SMD-Verfahrens zu integrieren.

Die Leiterplattenanordnung umfasst vorzugsweise eine Vielzahl von erfindungsgemäßen elektrischen Kontaktanordnungen.

Weiter bevorzugt ist zwischen dem Montagering und der Leiterplatte der Leiterplattenanordnung eine Lötverbindung ausgebildet. Besonders bevorzugt ist die Lötverbindung eine Reflow-Lötverbindung. Dadurch kann die Montage des Montagerings auf die Oberfläche der Isolationslage der Leiterplatte einfach und kostengünstig ausgeführt werden.

Gemäß einer besonders bevorzugten Ausgestaltung der Erfindung umfasst die Leiterplattenanordnung ferner eine zweite Leiterplatte oder dgl., wobei die flexible erste Zone des Einpressstifts mittels einer zweiten Pressverbindung mit der zweiten Leiterplatte verbunden ist. Statt der Leiterplatten kann eine elektrische Kontaktierung selbstverständlich auch von anderen Bauelementen mittels der erfindungsgemäßen elektrischen Kontaktanordnung erfolgen.

Die erste Leiterplatte ist vorzugsweise eine IMS-Leiterplatte und weist vorzugsweise nur an einer Seite eines Metallsubstrats oder dgl. eine elektrisch isolierende Isolationslage auf.

Die Isolationslage ist vorzugsweise aus einem schwer entflammbaren Verbundwerkstoff hergestellt und ist insbesondere eine FR4-Lage.

Somit kann bei der erfindungsgemäßen Leiterplattenanordnung auch eine Vielzahl von Steckverbindungen durch die elektrische Kontaktanordnung mit erster und zweiter Zone schnell und kostengünstig realisiert werden.

Die Leiterplattenanordnung wird vorzugsweise in einem Steuergerät von Fahrzeugen verwendet.

Weiterhin betrifft die vorliegende Erfindung ein Verfahren zur Herstellung einer Leiterplattenanordnung mit einer ersten Leiterplatte aus einem isolierten Metallsubstrat, insbesondere einer IMS-Leiterplatte, und einer zweiten Leiterplatte oder dgl., umfassend die Schritte:
- Bereitstellen der ersten Leiterplatte,
- Durchführen einer SMD-Fertigung (surface mount device-Fertigung) zur Fixierung wenigstens eines SMD-Bauteils und wenigstens eines Montagerings einer erfindungsgemäßen elektrischen Kontaktanordnung innerhalb des SMD-Prozesses,
- Einpressen eines Einpressstifts der elektrischen Kontaktanordnung in den auf der ersten Leiterplatte fixierten Montagering, so dass eine erste Pressverbindung zwischen dem Einpressstift und dem Montagering ausgebildet ist, und
- Einpressen einer zweiten Leiterplatte oder dgl. auf den wenigstens einen Einpressstift an der ersten Leiterplatte, um eine zweite Pressverbindung zwischen dem Einpressstift und der zweiten Leiterplatte herzustellen.

Durch das erfindungsgemäße Verfahren ist es somit möglich, dass die Fixierung von elektrischen Kontaktanordnungen innerhalb einer SMD-Fertigung erfolgt. Der Montagering der elektrischen Kontaktanordnung ist somit ein SMD-Bauteil, so dass die Montage eine einfache Prozessführung und Überwachung ermöglicht. Dabei können die Montageringe beispielsweise als Schüttgut über eine entsprechende Zufuhreinrichtung, z.B. ein Bestückungsautomat, auf die Leiterplatte zugeführt werden und auf dieser, insbesondere mittels Löten, fixiert werden.

### Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Seitenansicht eines Einpressstifts einer elektrischen Kontaktanordnung gemäß einem bevorzugten Ausführungsbeispiel der Erfindung,
- Figur 2: eine Draufsicht eines Montagerings der elektrischen Kontaktanordnung,
- Figur 3: eine schematische Schnittansicht der gesamten elektrischen Kontaktanordnung, und
- Figur 4: eine schematische Schnittansicht einer Leiterplattenanordnung mit mehreren elektrischen Kontaktanordnungen gemäß den Figuren 1 bis 3.

### Ausführungsform der Erfindung

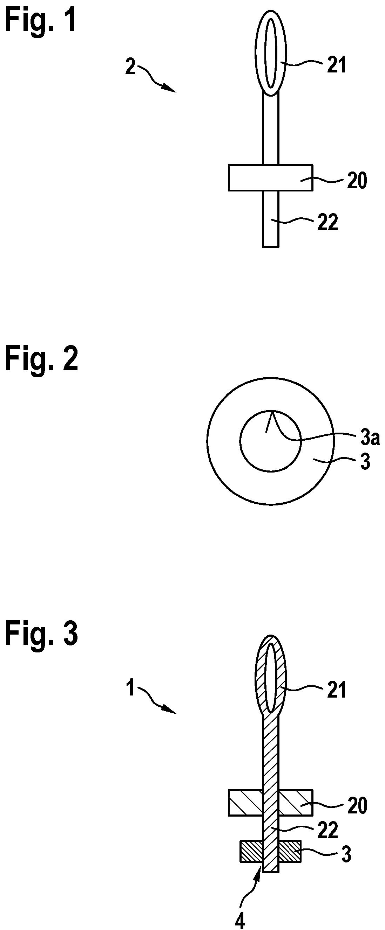

Nachfolgend wird unter Bezugnahme auf die Figuren 1 bis 4 eine elektrische Kontaktanordnung 1 und eine Leiterplattenanordnung 10 sowie ein Verfahren zur Herstellung einer Leiterplattenanordnung gemäß einem bevorzugten Ausführungsbeispiel der Erfindung im Detail beschrieben.

Die Figuren 1 bis 3 zeigen die elektrische Kontaktanordnung 1 gemäß der Erfindung. Die elektrische Kontaktanordnung umfasst dabei zwei Hauptbauteile, nämlich einen Montagering 3 (Figur 2) sowie einen Einpressstift 2, welcher im Detail aus Figur 1 ersichtlich ist. Figur 3 zeigt den zusammengesetzten Zustand des Montagerings 3 mit dem Einpressstift 2.

Der Montagering 3 ist ein geschlossener Ring aus einem elektrisch leitenden Material, vorzugsweise Metall. Der Montagering 3 weist dabei eine innere Öffnung 3a auf. Die innere Öffnung 3a ist eingerichtet, den Einpressstift 2 aufzunehmen.

Der Einpressstift 2 umfasst eine erste Zone 21 und eine zweite Zone 22. Die erste Zone 21 weist eine größere mechanische Flexibilität als die zweite Zone 22 auf. Somit ist die zweite Zone 22 die steifere Zone des Einpressstifts. Die zweite Zone 22 ist dabei im Wesentlichen ein zylinderförmiger Vollmaterialstift.

Die erste Zone 21 ist in diesem Ausführungsbeispiel ein von der Ausgangsform, z.B. eines zylindrischen Stiftes, geometrisch umgeformter Bereich, welcher als ovale Öse ausgebildet ist. Hierbei kann Rohmaterial an einem freien Ende des Rohmaterials zu einem geometrisch zu einer geschlossenen Öse umgeformten Bereich der ersten Zone 21 umgeformt werden und anschließend das Rohmaterial entsprechend einer gewünschten Länge des Einpressstifts abgelängt werden. Dadurch wird die zweite Zone 22, welche unbehandeltes Rohmaterial, beispielsweise ein Drahtmaterial, sein kann, erzeugt.

Der Einpressstift 2 umfasst ferner als Einpresshilfseinrichtung 20 eine Einpressschulter, welche in diesem Ausführungsbeispiel ein umlaufend geschlossener Ring ist, welcher an die zweite steifere Zone 22 des Einpressstifts 2 fixiert ist. Dies kann beispielsweise mittels einer Lötverbindung oder einer Schweißverbindung erfolgen.

Figur 1 zeigt aus Seitenansicht den fertig hergestellten Einpressstift 2 mit erster Zone 21, stabförmiger, steiferer zweiter Zone 22 und der Einpressschulter.

Es sei angemerkt, dass die erste Zone 21 auch durch Befestigung einer Öse oder eines Rings aus einem anderen Material an einem stabförmigen Material, welches die zweite Zone 22 des Einpressstifts 2 bereitstellt, hergestellt werden kann.

Figur 3 zeigt den montierten Zustand, bei dem der Einpressstift 2 in die Öffnung 3a des Montagerings 3 eingepresst ist. Hierdurch ergibt sich eine erste Pressverbindung 4 zwischen dem Montagering 3 und dem Einpressstift 2 im Bereich des zweiten freien Endes des Einpressstifts 2.

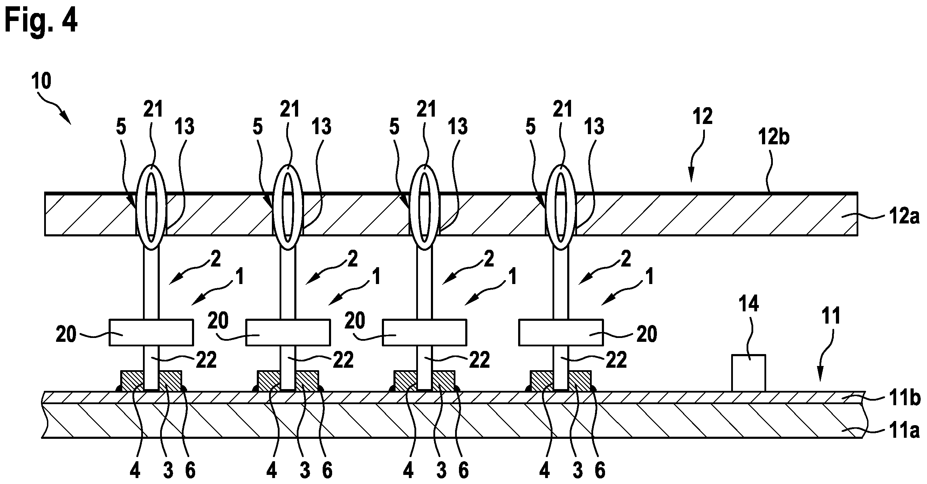

Figur 4 zeigt die Leiterplattenanordnung 10 mit einer Vielzahl von elektrischen Kontaktanordnungen 1. Die Leiterplattenanordnung 10 umfasst eine erste Leiterplatte 11 und eine zweite Leiterplatte 12, welche mit einem Abstand über der ersten Leiterplatte 11 angeordnet ist. Die Leiterplattenanordnung 10 umfasst ferner eine Vielzahl von elektrischen Kontaktanordnungen 1. Anhand der Figur 4 wird auch das erfindungsgemäße Verfahren erläutert.

Wie aus Figur 4 ersichtlich ist, ist die erste Leiterplatte 11 eine IMS-Leiterplatte mit einem Metallkörper 11a und einer Isolationslage 11b aus einem FR4-Material. Auf dem FR4-Material können eine Vielzahl von elektronischen Bauteilen 14 mittels SMD-Technik fixiert werden. Figur 4 zeigt schematisch ein auf der Isolationslage 11b fixiertes SMD-Bauteil 14. Der Montagering 3 der elektrischen Kontaktanordnung 1 ist hierbei ebenfalls als SMD-Bauteil vorgesehen und wird mittels einer Lötverbindung 6 auf die Oberfläche der Isolationslage 11b fixiert. Dadurch ist es möglich, die Fixierung des Montagerings 3 in den sowieso vorhandenen SMD-Fertigungsprozess zu integrieren. Dadurch kann die Herstellung der ersten Leiterplatte 11 sehr kostengünstig und in kürzester Zeit ausgeführt werden.

Zur Vervollständigung der elektrischen Kontaktanordnung wird nun der Einpressstift 2 in den auf der Oberfläche der Isolationslage 11b fixierten Montagering 3 eingepresst, so dass die erste Pressverbindung 4 zwischen dem Montagering 3 und dem Einpressstift 2 ausgebildet ist. Dies wird mittels eines nicht gezeigten Einpresswerkzeugs erreicht, welches an die Einpressschulter des Einpressstifts 2 angreift.

Dabei können die Einpressstifte 1 einzeln in einen jeweiligen Montagering 3 eingepresst werden oder mehrere Einpressstifte 2 werden parallel in jeweilige Montageringe 3 eingepresst.

In einem letzten Schritt wird dann die zweite Leiterplatte 12 auf die von der Oberfläche der ersten Leiterplatte 11 vorstehenden Einpressstifte 2 eingepresst. Hierzu werden die ersten Zonen 21 in Durchgangsöffnungen 13 der zweiten Leiterplatte 12 eingeführt, so dass eine zweite Pressverbindung 5 jeweils zwischen der ersten Zone 21 des Einpressstifts 2 und der zweiten Leiterplatte 12 ausgebildet ist.

Die zweite Leiterplatte 12 weist einen Isolationsträger 12a aus einem FR4-Material und elektrische Leitungen 12b auf einer Oberfläche des Isolationsträgers 12a auf.

Somit können erfindungsgemäß in einem Schritt eine Vielzahl von elektrischen Kontaktierungen zwischen der ersten Leiterplatte 11 und der zweiten Leiterplatte 12 erreicht werden. Dabei sind die Einpressstifte 2 vorzugsweise alle identisch ausgebildet.

Somit kann eine Leiterplattenanordnung 10 unter Beibehaltung eines üblichen SMD-Fertigungsprozesses ohne Sonderprozesse ermöglicht werden. Dabei ist eine freie Gestaltung der elektrischen Kontaktierung insbesondere hinsichtlich einer Position und einer Anzahl möglich. Auch kann eine schnelle Anpassung an unterschiedlichste Anforderungen bzw. eine schnelle Umstellung der Fertigung auf eine andere Leiterplattenanordnung ermöglicht werden. Die Fügeschritte können dabei ohne Wärmebehandlung der Leiterplatten 11, 12 ausgeführt werden. Somit ergibt sich auch eine einfache Prozessführung und Überwachung.

## Patentansprüche

1. Elektrische Kontaktanordnung (1) zur elektrischen Kontaktierung an einer Leiterplatte (11) oder dgl., umfassend:
- einen Montagering (3), wobei der Montagering (3) eingerichtet ist, an der Leiterplatte (11) fixiert zu werden, und
- einen Einpressstift (2) mit einer ersten Zone (21) und einer zweiten Zone (22), wobei die erste Zone (21) eine größere mechanische Flexibilität als die zweite Zone (22) aufweist,
- wobei die erste Zone (21) eingerichtet ist, mit einem weiteren elektronischen Bauteil verbunden zu werden, und
**dadurch gekennzeichnet, dass**
der Montagering (3) eine Öffnung (3a) aufweist,
die zweite Zone (22) mittels einer ersten Presspassung (4) in die Öffnung (3a) des Montagerings (3) gefügt ist,
und die elektrische Kontaktanordnung (1) eine Einpresshilfseinrichtung (20) umfasst, welche an der zweiten Zone (22) angeordnet ist, wobei die Einpresshilfseinrichtung (20)
als umlaufender geschlossener Ringflansch an der zweiten Zone (22) fixiert ist,
wobei der umlaufende Ringflansch eine Einpressschulter für den Angriff eines Einpresswerkzeugs umfasst.

2. Elektrische Kontaktanordnung (1) nach Anspruch 1, wobei der Einpressstift (2) einstückig aus einem Material hergestellt ist.

3. Elektrische Kontaktanordnung (1) nach einem der vorhergehenden Ansprüche, wobei die erste Zone (21) des Einpressstifts (2) ein geometrisch umgeformter Bereich ist, insbesondere eine ovale Hülse oder ein Ring.

4. Elektrische Kontaktanordnung (1) nach einem der vorhergehenden Ansprüche, wobei die zweite Zone (22) aus einem, insbesondere zylindrischen, Vollmaterial hergestellt ist.

5. Elektrische Kontaktanordnung (1) nach einem der vorhergehenden Ansprüche, wobei die erste Zone (21) für eine zweite Presspassung (5) mit dem weiteren elektronischen Bauteil eingerichtet ist.

6. Leiterplattenanordnung (10), umfassend:
- eine erste Leiterplatte (11), welche einen Basisbereich (11a) aus einem elektrisch leitfähigen Material und eine auf dem Basisbereich (11a) angeordnete Isolationslage (11b) aus einem elektrisch nichtleitenden Material aufweist, und
- eine elektrische Kontaktanordnung (1) gemäß einem der vorhergehenden Ansprüche,
- wobei der Montagering (3) der elektrischen Kontaktanordnung (1) auf der Isolationslage (11b) fixiert ist.

7. Leiterplattenanordnung (10) nach Anspruch 6, wobei zwischen der ersten Leiterplatte (11) und dem Montagering (3) eine Lötverbindung oder eine Schweißverbindung ausgebildet ist.

8. Leiterplattenanordnung (10) nach Anspruch 6 oder 7, ferner umfassend eine zweite Leiterplatte (12) oder dgl., wobei zwischen der zweiten Leiterplatte (12) und der ersten Zone (21) des Einpressstifts (2) eine zweite Pressverbindung (5) ausgebildet ist.

9. Leiterplattenanordnung (10) nach einem der Ansprüche 6 bis 8, wobei die erste Leiterplatte (11) aus einem isolierten Metallsubstrat hergestellt und insbesondere eine IMS-Leiterplatte ist.

10. Leiterplattenanordnung (10) nach einem der Ansprüche 6 bis 9, wobei an einer Seite des Basisbereichs (11a) eine Isolationslage (11b) aus einem schwer entflammbaren Verbundwerkstoff, insbesondere FR4, hergestellt ist.

11. Verfahren zur Herstellung einer Leiterplattenanordnung (10) mit einer ersten Leiterplatte (11) aus einem isolierten Metallsubstrat, insbesondere eine IMS-Leiterplatte, und einer zweiten Leiterplatte (12), umfassend die Schritte
- Bereitstellen der ersten Leiterplatte (11),
- Durchführen eines SMD-Prozesses zur Fixierung wenigstens eines SMD-Bauteils (14) und wenigstens eines Montagerings (3) einer elektrischen Kontaktanordnung (1) nach einem der Ansprüche 1 bis 5 innerhalb des SMD-Prozesses,
- Einpressen eines Einpressstifts (2) in den auf der ersten Leiterplatte (11) fixierten Montagering (3), so dass eine erste Pressverbindung (4) zwischen dem Einpressstift (2) und dem Montagering (3) ausgebildet ist, wobei der Einpressstift (2) eine erste Zone (21) und eine zweite Zone (22) aufweist, wobei die erste Zone (21) flexibler als die zweite Zone (22) ist und die zweite Zone (22) an der ersten Pressverbindung (4) ausgebildet ist, und
- Einpressen der zweiten Leiterplatte (12) auf den wenigstens einen Einpressstift (2) an der ersten Zone (21) des Einpressstifts (2), um eine zweite Pressverbindung (5) zwischen dem Einpressstift (2) und der zweiten Leiterplatte (12) herzustellen.

## Claims

1. Electrical contact arrangement (1) for electrically contacting a printed circuit board (11) or the like, comprising:
- a mounting ring (3), wherein the mounting ring (3) is designed to be fixed to the printed circuit board (11), and
- a press-in pin (2) having a first zone (21) and a second zone (22), wherein the first zone (21) exhibits greater mechanical flexibility than the second zone (22),
- wherein the first zone (21) is designed to be connected to a further electronic component, and
**characterized in that**
the mounting ring (3) has an opening (3a),
the second zone (22) is fitted into the opening (3a) in the mounting ring (3) by means of a first press fit (4),
and the electrical contact arrangement (1) comprises a press-in assistance device (20) which is arranged on the second zone (22), wherein the press-in assistance device (20)
is fixed on the second zone (22) as a circumferential closed ring flange,
wherein the circumferential ring flange comprises a press-in shoulder for a press-in tool to act on.

2. Electrical contact arrangement (1) according to Claim 1, wherein the press-in pin (2) is produced in one piece from one material.

3. Electrical contact arrangement (1) according to either of the preceding claims, wherein the first zone (21) of the press-in pin (2) is a geometrically formed region, in particular an oval sleeve or a ring.

4. Electrical contact arrangement (1) according to any of the preceding claims, wherein the second zone (22) is produced from an, in particular cylindrical, solid material.

5. Electrical contact arrangement (1) according to any of the preceding claims, wherein the first zone (21) is designed for a second press fit (5) with the further electronic component.

6. Printed circuit board arrangement (10), comprising:
- a first printed circuit board (11), which has a base region (11a) composed of an electrically conductive material and has an insulation layer (11b) arranged on the base region (11a) and composed of an electrically non-conductive material, and
- an electrical contact arrangement (1) according to any of the preceding claims,
- wherein the mounting ring (3) of the electrical contact arrangement (1) is fixed on the insulation layer (11b).

7. Printed circuit board arrangement (10) according to Claim 6, wherein a soldered connection or a welded connection is formed between the first printed circuit board (11) and the mounting ring (3).

8. Printed circuit board arrangement (10) according to Claim 6 or 7, further comprising a second printed circuit board (12) or the like, wherein a second press-fit connection (5) is formed between the second printed circuit board (12) and the first zone (21) of the press-in pin (2).

9. Printed circuit board arrangement (10) according to any of Claims 6 to 8, wherein the first printed circuit board (11) is produced from an insulated metal substrate and in particular an IMS printed circuit board.

10. Printed circuit board arrangement (10) according to any of Claims 6 to 9, wherein an insulation layer (11b) composed of a flame-resistant composite material, in particular FR4, is produced on one side of the base region (11a).

11. Method for producing a printed circuit board arrangement (10) comprising a first printed circuit board (11) composed of an insulated metal substrate, in particular an IMS printed circuit board, and a second printed circuit board (12), comprising the steps of
- providing the first printed circuit board (11),
- carrying out an SMD process for fixing at least one SMD component (14) and at least one mounting ring (3) of an electrical contact arrangement (1) according to any of Claims 1 to 5 within the SMD process,
- pressing a press-in pin (2) into the mounting ring (3) fixed on the first printed circuit board (11), so that a first press-fit connection (4) is formed between the press-in pin (2) and the mounting ring (3), wherein the press-in pin (2) has a first zone (21) and a second zone (22), wherein the first zone (21) is more flexible than the second zone (22) and the second zone (22) is formed on the first press-fit connection (4), and
- pressing the second printed circuit board (12) onto the at least one press-in pin (2) in the first zone (21) of the press-in pin (2) in order to establish a second press-fit connection (5) between the press-in pin (2) and the second printed circuit board (12).

## Revendications

1. Arrangement de contact électrique (1) destiné à établir un contact électrique au niveau d'une carte de circuit imprimé (11) ou analogue, comprenant :
- une bague de montage (3), la bague de montage (3) étant conçue pour être calée au niveau de la carte de circuit imprimé (11), et
- une broche à enfoncer (2) pourvue d'une première zone (21) et d'une deuxième zone (22), la première zone (21) présentant une plus grande flexibilité mécanique que la deuxième zone (22),
- la première zone (21) étant conçue pour être connectée à un composant électronique supplémentaire, et
**caractérisé en ce que**
la bague de montage (3) présente une ouverture (3a),
la deuxième zone (22) est jointe dans l'ouverture (3A) de la bague de montage (3) au moyen d'un premier ajustement serré (4),
et l'arrangement de contact électrique (1) comporte un dispositif auxiliaire d'enfoncement (20), lequel est disposé au niveau de la deuxième zone (22), le dispositif auxiliaire d'enfoncement (20)
étant calé au niveau de la deuxième zone (22) sous la forme d'une bride annulaire fermée sur la circonférence,
la bride annulaire circonférentielle comportant un épaulement d'enfoncement pour la prise d'un outil d'enfoncement.

2. Arrangement de contact électrique (1) selon la revendication 1, la broche à enfoncer (2) étant fabriquée d'une seule pièce à partir d'un matériau.

3. Arrangement de contact électrique (1) selon l'une des revendications précédentes, la première zone (21) de la broche à enfoncer (2) étant une zone déformée géométriquement, en particulier une douille ovale ou une bague.

4. Arrangement de contact électrique (1) selon l'une des revendications précédentes, la deuxième zone (22) étant fabriquée en un matériau plein, en particulier cylindrique.

5. Arrangement de contact électrique (1) selon l'une des revendications précédentes, la première zone (21) étant conçue pour un deuxième ajustement serré (5) avec le composant électronique supplémentaire.

6. Arrangement de carte de circuit imprimé (10), comprenant :
- une première carte de circuit imprimé (11), laquelle possède une zone de base (11a) en un matériau électriquement conducteur et une couche isolante (11b) en un matériau électriquement non conducteur disposée sur la zone de base (11a), et
- un arrangement de contact électrique (1) selon l'une des revendications précédentes,
- la bague de montage (3) de l'arrangement de contact électrique (1) étant calée sur la couche isolante (11b).

7. Arrangement de carte de circuit imprimé (10) selon la revendication 6, une connexion brasée ou une connexion soudée étant formée entre la première carte de circuit imprimé (11) et la bague de montage (3).

8. Arrangement de carte de circuit imprimé (10) selon la revendication 6 ou 7, comportant en outre une deuxième carte de circuit imprimé (12) ou analogue, une deuxième connexion par ajustement serré (5) étant formée entre la deuxième carte de circuit imprimé (12) et la première zone (21) de la broche à enfoncer (2).

9. Arrangement de carte de circuit imprimé (10) selon l'une des revendications 6 à 8, la première carte de circuit imprimé (11) étant fabriquée à partir d'un substrat métallique isolé et étant notamment une carte de circuit imprimé IMS.

10. Arrangement de carte de circuit imprimé (10) selon l'une des revendications 6 à 9, une couche isolante (11b) en un matériau composite difficilement inflammable, en particulier du FR4, étant produite sur un côté de la zone de base (11a).

11. Procédé de fabrication d'un arrangement de carte de circuit imprimé (10) comprenant une première carte de circuit imprimé (11) en un substrat métallique isolé, en particulier une carte de circuit imprimé IMS, et une deuxième carte de circuit imprimé (12), comprenant les étapes suivantes
- fourniture de la première carte de circuit imprimé (11),
- mise en œuvre d'un procédé CMS pour le calage d'au moins un composant CMS (14) et d'au moins une bague de montage (3) d'un arrangement de contact électrique (1) selon l'une des revendications 1 à 5 au sein du procédé CMS,
- enfoncement d'une broche à enfoncer (2) dans la bague de montage (3) calée au niveau de la première carte de circuit imprimé (11), de telle sorte qu'une première connexion par ajustement serré (4) soit formée entre la broche à enfoncer (2) et la bague de montage (3), la broche à enfoncer (2) présentant une première zone (21) et une deuxième zone (22), la première zone (21) étant plus flexible que la deuxième zone (22) et la deuxième zone (22) étant formée au niveau de la première connexion par ajustement serré (4), et
- enfoncement de la deuxième carte de circuit imprimé (12) sur l'au moins une broche à enfoncer (2) au niveau de la première zone (21) de la broche à enfoncer (2) afin de produire une deuxième connexion par ajustement serré (5) entre la broche à enfoncer (2) et la deuxième carte de circuit imprimé (12).
